Europäisches Patentamt

European Patent Office

Office européen des brevets

(11) Numéro de publication : **0 425 325 B1**

(12) **FASCICULE DE BREVET EUROPEEN**

(45) Date de publication du fascicule du brevet :
08.12.93 Bulletin 93/49

(51) Int. Cl.⁵ : **C30B 9/00,** C30B 29/20

(21) Numéro de dépôt : **90402599.6**

(22) Date de dépôt : **20.09.90**

(54) **Macrocristaux d'alumine alpha sous forme de plaquettes et procédé d'obtention.**

(30) Priorité : **21.09.89 FR 8912402**

(43) Date de publication de la demande :
**02.05.91 Bulletin 91/18**

(45) Mention de la délivrance du brevet :
**08.12.93 Bulletin 93/49**

(84) Etats contractants désignés :
**AT BE CH DE DK ES FR GB GR IT LI LU NL SE**

(56) Documents cités :
**DE-A- 2 623 482
DE-A- 2 850 064
FR-A- 2 319 580
GB-A- 935 390
JOURNAL OF CRYSTAL GROWTH, vol. 57, no.
2, avril 1982, pages 367-378, Amsterdam, NL;
K. WATANABE: "Surface micro-topography of
corundum crystals grown from cryolite flux"**

(73) Titulaire : **ELF ATOCHEM S.A.
4 & 8, Cours Michelet La Défense 10
F-92800 Puteaux (FR)**

(72) Inventeur : **Faure, Annick
18 Rue Ludovic Bonin
F-69200 Venissieux (FR)**
Inventeur : **Bachelard, Roland
99 Grande Rue de la Guillotière
F-69007 Lyon (FR)**

(74) Mandataire : **Rochet, Michel et al
ELF ATOCHEM S.A. Département Propriété
Industrielle 4-8, Cours Michelet La Défense 10
- Cedex 42
F-92091 Paris-La-Défense (FR)**

## Description

L'invention a pour objet des macrocristaux d'alumine α ou oxyde d'aluminium ou corindon, se présentant sous forme de plaquettes hexagonales, ainsi qu'un procédé de préparation desdits cristaux à partir d'oxyde ou d'hydroxyde d'aluminium.

On a déjà décrit la préparation de macrocristaux d'alumine à partir d'hydroxyde d'aluminium. Ainsi, dans le brevet français 2 441 584, on propose des macrocristaux d'alumine α, en forme de plaquettes hexagonales d'une granulométrie de 16 à 250 μm et de rapport diamètre/épaisseur compris entre 3/1 et 7/1, ces macrocristaux étant obtenus par calcination à une température comprise entre 1200°C et 1450°C d'hydroxyde d'aluminium en présence d'un minéralisateur contenant 0,001 à 0,5 % en poids de composés fluorés.

Dans la demande de brevet allemand DE-OS 2 623 482, on a proposé de préparer des cristaux primaires ayant une dimension moyenne comprise entre 16 et 25 μm par calcination d'hydroxyde d'aluminium en présence d'au moins un sel fluoré et d'un sel de vanadium. D'après le brevet français cité plus haut (page 2 lignes 19-22) l'augmentation de la température ou l'utilisation d'autres minéralisateurs n'influencent pas du tout ou presque pas la dimension et la forme des cristaux.

Par ailleurs Keiji DAIMON et Etsun KATO ont proposé (Yogyo Kvokai Shi 94 [3] 1986 pp. 380-382 [78-80]) de fabriquer des plaquettes hexagonales d'alumine α de diamètre compris entre 1,5 et 40 μm, à partir de sulfate d'aluminium hydraté, en présence de trifluorure d'aluminium.

Dans la demande de brevet japonais 60/54916, on a proposé de préparer, à partir d'un mélange de sulfate d'aluminium hydraté et d'un carbonate alcalin, des plaquettes de diamètre moyen de 1,7 μm et d'épaisseur 0,18 μm.

Dans la demande de brevet japonais 60/38486, on a proposé de préparer des plaquettes d'épaisseur inférieure à 5 μm et de diamètre compris (à partir du rapport diamètre/épaisseur) entre 25 et 150 μm.

Dans le brevet russe 416313, on a proposé de préparer des plaquettes hexagonales d'alumine, dont le diamètre est compris entre 4 et 12 μm, par dissociation thermique d'un composé d'aluminium en présence de germe d'alumine hexagonale à 1170°C.

Enfin, B.P. LOCSEL a proposé dans INTERCERAM NR 3, 1981 pp. 197-198 de préparer des cristaux d'alumine α ayant un rapport diamètre/épaisseur compris entre 6 et 10 à partir de bauxite ayant une faible teneur en oxyde ferrique, en présence de trifluorure d'aluminium.

L'invention a pour objet de nouveaux macrocristaux d'alumine α, se présentant essentiellement sous forme de plaquettes hexagonales monocristallines, lesdites plaquettes étant caractérisées en ce qu'elles présentent un diamètre compris entre 2 et 20 μm, une épaisseur comprise entre 0,1 et 2 μm, et un rapport diamètre/épaisseur compris entre 5 et 40.

Parmi ces macrocristaux, l'invention concerne plus particulièrement des macrocristaux d'alumine α sous forme de plaquettes hexagonales présentant un diamètre compris entre 2 et 18 μm, une épaisseur comprise entre 0,1 et 1 μm, et un rapport diamètre/épaisseur compris entre 5 et 40.

L'invention a également pour objet un procédé de fabrication d'alumine α sous forme de plaquettes essentiellement hexagonales telles que définies ci-avant, ce procédé étant caractérisé en ce qu'il consiste à effectuer la calcination d'alumine de transition ou d'alumine hydratée en présence d'un fondant dont le point de fusion est au plus égal à 800°C, contenant du fluor lié chimiquement et solvant à l'état fondu de l'alumine de transition ou hydratée.

L'expression "alumine de transition ou hydratée" est utilisée pour signifier que ce procédé s'applique à toutes les formes d'oxyde ou d'hydroxyde d'aluminium, à l'exception de l'alumine α.

Le fondant, également appelé minéralisant, répondant aux caractéristiques définies ci-avant, est essentiellement constitué par un ou plusieurs composé(s) fluoré(s) non hydrolysable(s) ou par un couple comprenant une phase constituée par ledit ou lesdits composé(s) fluoré(s) non hydrolysable(s) et par une phase constituée par un composé fluoré hydrolysable, l'une desdites phases étant dissoute dans l'autre phase.

A titre d'illustration des fondants précités, on mentionnera tout particulièrement les couples comprenant le trifluorure d'aluminium et un ou plusieurs fluorure(s) alcalin(s) ou alcalino-terreux, et notamment les fluorures de lithium, sodium, potassium ou calcium. On retiendra plus spécifiquement le couple $AlF_3$-$LiF$ sous la forme $Li_3AlF_6$ (cryolithe lithique) ou encore $Li_3Na_3(AlF_6)_2$ (cryolithionite) ou 3 $AlF_3$, 5 $LiF$ (chiolite lithique).

Les fondants utilisés dans l'invention se présentent sous forme de poudre dont la granulométrie est de préférence inférieure à 1 mm (pour au moins 50 % en poids des grains).

Dans la mise en oeuvre du procédé conforme à l'invention, on utilise au moins 2 % et de préférence 4 à 20 % en poids de fondant par rapport au poids de l'alumine de transition ou hydratée engagée.

L'alumine de transition ou hydratée peut être choisie dans une large gamme de produits en poudres de diamètres et surfaces spécifiques variés. On retiendra tout particulièrement les alumines dont au moins 50 % en poids des grains ont un diamètre inférieur à 50 μm, et de préférence inférieur à 25 μm et plus encore à 1,5

2

μm. Parmi ces alumines, on donnera la préférence aux alumines présentant une surface spécifique égale ou supérieure à 100 m²/g (mesurée selon la méthode BET) et de préférence comprise entre 100 et 400 m²/g.

Bien que les alumines séchées puissent être utilisées, on donnera la préférence aux variétés non séchées ou hydratées ($Al_2O_3$, $H_2O$) la teneur en eau pouvant atteindre 15 % du poids de l'alumine.

La température de calcination peut atteindre 1200°C voire davantage. Cependant, et ceci constitue un intérêt tout particulier du procédé conforme à l'invention, la calcination peut être réalisée à une température très inférieure, par exemple comprise entre 900 et 1100°C.

D'une manière générale, le mélange alumine de transition ou hydratée/fondant, préparé par les techniques habituelles de mélanges de poudres, peut être placé à température ambiante dans une enceinte chauffante, la température étant progressivement élevée jusqu'aux valeurs précitées. La température est avantageusement élevée d'une manière rapide, c'est-à-dire de l'ordre de 1000°C à l'heure, cette indication ne devant en aucun cas limiter le domaine de l'invention.

La calcination est avantageusement conduite en atmosphère inerte, par exemple sous léger courant d'azote. Une fois la température de calcination atteinte, température qui, ainsi qu'il a été précisé, peut se situer entre 900 et 1100°C et plus précisément autour de 1000°C, il est avantageux de maintenir cette température pendant une période pouvant aller d'une demi-heure à quelques heures (par exemple jusqu'à 5 heures).

A l'issue de l'opération de calcination, on peut indifféremment effectuer une trempe de plaquettes ou les laisser refroidir naturellement ou en enceinte réfrigérée.

Les plaquettes recueillies sont essentiellement (> 95 % en poids) constituées d'alumine α, éventuellement associée au fondant ou à un produit dérivé du fondant tel que $Al_4LiO_6F$ dans le cas de $Li_3AlF_6$. Le fondant ou son dérivé peut être éliminé par exemple par action d'un acide concentré ($H_2SO_4$ ou HCl) à chaud (par exemple autour de 100°C).

Les plaquettes hexagonales d'alumine α, objet de la présente invention, sont susceptibles de nombreuses applications. Elles peuvent notamment servir à la fabrication de produits de polissage et en tant que matériaux de renforcement de matières diverses, en particulier de matrices céramiques et de matrices métalliques et polymériques, seules ou associées à des fibres, à des particules, à des whiskers.

Les exemples suivants permettront d'illustrer l'invention.

## EXEMPLES 1 A 14

Le matériel utilisé est composé d'un four à chauffage par tube de quartz dans lequel on peut faire circuler un courant d'azote et dans lequel sont introduits des creusets en alumine frittée, renfermant la poudre à calciner.

On utilise les alumines suivantes (DX = Y μm signifie que X % des grains (en poids) ont un diamètre inférieur à Y μm) :

- $P_1$ : $Al_2O_3$ gamma $D_{50}$ = 1,1 μm surface spécifique = 172 m²/g
- $P_2$ : $Al_2O_3$ gamma $D_{50}$ = 4,6 μm surface spécifique = 100 m²/g
- $P_3$ : $Al_2O_3H_2O$ (boehémite) $D_{60}$ = 25 μm $D_{96}$ = 45 μm surface spécifique = 196 m²/g
- $P_4$ : $Al_2O_3$ gamma $D_{55}$ = 25 μm $D_{97}$ = 45 μm surface spécifique = 244 m²/g
- $P_5$ : $Al_2O_3$ gamma $D_{50}$ = 3,5 μm

On utilise les fondants suivants ($D_{50}$ = μm ayant la signification donnée ci-avant et D correspondant à la totalité des grains) à raison de 5 % en poids par rapport au poids d'alumine ($P_1$ à $P_5$) :

- $F_1$ : $Li_3AlF_6$ (Pf : 776°C) $D_{50}$= 0,9 μm
- $F_2$ : $Li_3AlF_6$ 400 <D <600 μm
- $F_3$ : $Li_3AlF_6$ D > 630 μm
- $F_4$ : $Li_3AlF_6$ 160 < D <400 μm
- $F_5$ : $Li_3Na_3(AlF_6)_2$ (Pf : 710°C)
- $F_6$ : 3 $AlF_3$, 5 LiF

Les mélanges d'alumines et de fondant sont effectués à température ambiante, puis placés dans des creusets et ceux-ci sont introduits dans le four, sous courant d'azote (10 l/h).

La température du four est élevée à X°C en une heure (montée) puis maintenue à cette température pendant Z heures (palier).

Le refroidissement s'effectue à l'air ambiant.

Le produit obtenu est un bloc blanc qui se démoule et se désagglomère facilement. On mesure le diamètre moyen d (en μm) et l'épaisseur moyenne e (en μm) des plaquettes formées.

Les conditions et résultats sont rassemblées dans le tableau qui suit :

| Exemples | Alumine | Fondant | CALCINATION | | Dimensions des plaquettes | |
|---|---|---|---|---|---|---|
| | | | $X°C$ | Palier (Z) | d | e |
| 1 | $P_1$ | $F_1$ | 980 | 1 | 7 | 0,5 |
| 2 | $P_2$ | $F_1$ | 980 | 1 | 16 | 0,5 |
| 3 | $P_3$ | $F_1$ | 980 | 1 | 16 | 1 |
| 4 | $P_4$ | $F_1$ | 980 | 1 | 8 | 1 |
| 5 | $P_5$ | $F_1$ | 980 | 1 | 4 | 0,3 |
| 6 | $P_1$ | $F_2$ | 980 | 1 | 5 | 0,7 |
| 7 | $P_1$ | $F_3$ | 980 | 1 | 5 | 0,7 |
| 8 | $P_1$ | $F_4$ | 980 | 1 | 10 | 0,5 |
| 9 | $P_2$ | $F_4$ | 980 | 1 | 9 | 1 |
| 10 | $P_1$ | $F_1$ | 980 | 1/2 | 7 | 0,5 |
| 11 | $P_1$ | $F_1$ | 980 | 2 | 7 | 0,5 |
| 12 | $P_1$ | $F_1$ | 850 | 1 | 7 | 0,5 |
| 13 | $P_1$ | $F_1$ | 1100 | 1 | 7 | 0,5 |
| 14 | $P_1$ | $F_5$ | 980 | 1 | 8 | 0,5 |
| 15 | $P_1$ | $F_6$ | 980 | 1 | 7 | 0,5 |

EP 0 425 325 B1

**Revendications**

1.  Macrocristaux d'alumine α, se présentant essentiellement sous forme de plaquettes hexagonales monocristallines, caractérisés en ce que lesdites plaquettes présentent un diamètre compris entre 2 et 20 μm, une épaisseur comprise entre 0,1 et 2 μm et un rapport diamètre/épaisseur compris entre 5 et 40.

2.  Macrocristaux selon la revendication 1, caractérisés en ce que les plaquettes hexagonales présentent un diamètre compris entre 2 et 18 μm et une épaisseur comprise entre 0,1 et 1 μm.

3.  Procédé de fabrication des macrocristaux selon l'une quelconque des revendications 1 et 2, à partir d'alumine de transition ou d'alumine hydratée et d'un fondant, caractérisé en ce que le fondant utilisé présente un point de fusion au plus égal à 800°C, contient du fluor lié chimiquement et est solvant à l'état fondu de l'alumine de transition ou hydratée.

4.  Procédé selon la revendication 3, caractérisé en ce que le fondant est essentiellement constitué par un ou plusieurs composé(s) fluoré(s) non hydrolysable(s) ou par un couple comprenant une phase constituée par ledit ou lesdits composé(s) fluoré(s) et une deuxième phase constituée par un composé fluoré hydrolysable, l'une desdites phases étant dissoute dans l'autre phase.

5.  Procédé selon la revendication 4, caractérisé en ce que le fondant est constitué par un couple formé du trifluorure d'aluminium d'une part et d'un ou plusieurs fluorure(s) alcalin(s) ou alcalino-terreux d'autre part.

6.  Procédé selon la revendication 5, caractérisé en ce que le fluorure alcalin ou alcalino-terreux est choisi parmi les fluorures de lithium, sodium, potassium et calcium.

7.  Procédé selon l'une quelconque des revendications 4 à 6, caractérisé en ce que le fondant est constitué par AlF$_3$LiF sous la forme Li$_3$AlF$_6$ (cryolithe lithique), par Li$_3$Na$_3$(AlF$_6$)$_2$ (cryolithionite) ou 3 AlF$_3$, 5 LiF (chiolite lithique).

8.  Procédé selon l'une quelconque des revendications 4 à 7, caractérisé en ce que le fondant est utilisé à raison d'au moins 2 % et de préférence de 4 à 20 % de fondant par rapport au poids de l'alumine de transition ou hydratée soumise à calcination.

9.  Procédé selon l'une quelconque des revendications 4 à 8, caractérisé en ce que l'alumine de transition ou hydratée est constituée par une poudre dont au moins 50 % (en poids) des grains présentent un diamètre inférieur à 50 μm, ladite alumine ayant une surface spécifique supérieure à 100 m$^2$/g.

10. Procédé selon la revendication 8, caractérisé en ce que l'alumine renferme jusqu'à 15 % en poids d'eau.

11. Procédé selon l'une quelconque des revendications 4 à 10, caractérisé en ce que la température de calcination est comprise entre 900 et 1100°C.

12. Utilisation des macrocristaux d'alumine α selon l'une quelconque des revendications 1 ou 2, pour la confection de produits de polissage ou en tant que matériaux de renforcement de matrices, notamment de matrices en céramiques, de matrices métalliques ou polymériques.

**Patentansprüche**

1.  Makrokristalle aus α Aluminiumoxid, die vor allem in Form monokristalliner hexagonaler Plättchen auftreten, dadurch gekennzeichnet, daß die genannten Plättchen einen Durchmesser zwischen 2 und 20 μm, eine Dicke zwischen 0,1 und 2 μm und ein Verhältnis Durchmesser/Dicke zwischen 5 und 40 aufweisen.

2.  Makrokristalle nach Anspruch 1, dadurch gekennzeichnet, daß die hexagonalen Plättchen einen Durchmesser zwischen 2 und 18 μm und eine Dicke zwischen 0,1 und 1 μm besitzen.

3.  Verfahren zur Herstellung von Makrokristallen nach irgendeinem der Ansprüche 1 und 2 aus einer Aluminiumoxid-Vorstufe oder hydratisiertem Aluminiumoxid und einem Flußmittel, dadurch gekennzeichnet, daß das verwendete Flußmittel einen Schmelzpunkt von höchstens gleich 800°C besitzt, chemisch gebundenes Fluor enthält und im geschmolzenen Zustand ein Lösemittel für hydratisiertes Aluminiumoxid oder Aluminiumoxidvorstufen ist.

4. Verfahren nach Anspruch 3, dadurch gekennzeichnet, daß das Flußmittel vor allem aus einer oder aus mehreren nicht hydrolysierbaren fluorierten Verbindung(en) oder aus einer Zweiermischung besteht, die sich aus einer Phase mit der genannten oder den genannten fluorierten Verbindung(en) und aus einer zweiten Phase mit einer hydrolysierbaren fluorierten Verbindung zusammensetzt, wobei eine der genannten Phasen in der anderen Phase gelöst ist.

5. Verfahren nach Anspruch 4, dadurch gekennzeichnet, daß das Flußmittel aus einer Zweiermischung besteht, die zum einen aus Aluminiumtrifluorid und zum anderen aus einem oder mehreren Alkali-oder Erdalkalifluorid(en) besteht.

6. Verfahren nach Anspruch 4, dadurch gekennzeichnet, daß das Alkali- oder Erdalkalifluorid unter den Fluoriden von Lithium, Natrium, Kalium und Kalzium ausgewählt wird.

7. Verfahren nach irgendeinem der Ansprüche 4 bis 6, dadurch gekennzeichnet, daß das Flußmittel aus $AlF_3$-LiF in Form von $Li_3AlF_6$ (Lithiumkryolith), $Li_3Na_3(AlF_6)_2$ (Kryolithionit) oder 3 $AlF_3$, 5 LiF (Lithiumchiolith) besteht.

8. Verfahren nach irgendeinem der Ansprüche 4 bis 7, dadurch gekennzeichnet, daß das Flußmittel mit einem Gewichtsanteil von mindestens 2 % und bevorzugt von 4 bis 20 % am hydratisierten Aluminiumoxid oder zur Aluminiumoxidvorstufe, die kalziniert werden, eingesetzt wird.

9. Verfahren nach irgendeinem der Ansprüche 4 bis 8, dadurch gekennzeichnet, daß das hydratisierte Aluminiumoxid oder die Aluminiumoxidvorstufe aus einem Pulver besteht, von dem mindestens 50 % (bezogen auf das Gewicht) der Körner einen Durchmesser kleiner als 50 μm aufweisen, wobei das genannte Aluminiumoxid eine spezifische Oberfläche größer als 100 $m^2/g$ besitzt.

10. Verfahren nach Anspruch 8, dadurch gekennzeichnet, daß das Aluminiumoxid bis zu 15 Gewichtsprozente Wasser einschließt.

11. Verfahren nach irgendeinem der Ansprüche 4 bis 10, dadurch gekennzeichnet, daß die Kalzinierungstemperatur zwischen 900 und 1000°C liegt.

12. Verwendung der Makrokristalle aus α Aluminiumoxid nach irgendeinem der Ansprüche 1 oder 2 zur Herstellung von Poliermitteln oder als Verstärkungsmittel für Matrixmaterialien, besonders keramische, metallische oder polymere Matrixmaterialien.

## Claims

1. Macrocrystals of α alumina, essentially in the form of monocrystalline hexagonal platelets, characterised in that the said platelets have a diameter of between 2 and 20 μm, a thickness of between 0.1 and 2 μm and a diameter/thickness ratio of between 5 and 40.

2. Macrocrystals according to Claim 1, characterised in that the hexagonal platelets have a diameter of between 2 and 18 μm and a thickness of between 0.1 and 1 μm.

3. Process for the manufacture of the macrocrystals according to either of Claims 1 and 2, from transition alumina or from hydrated alumina and a flux, characterised in that the flux employed has a melting point not exceeding 800°C, contains chemically bonded fluorine and is a melt solvent for the transition or hydrated alumina.

4. Process according to Claim 3, characterised in that the flux consists essentially of one or a number of nonhydrolysable fluorine compound(s) or of a pair comprising a phase consisting of the said fluorine compound(s) and a second phase consisting of a hydrolysable fluorine compound, one of the said phases being dissolved in the other phase.

5. Process according to Claim 4, characterised in that the flux consists of a pair made up, on the one hand, of aluminium trifluoride and, on the other hand, of one or a number of alkali or alkaline-earth metal fluoride(s).

6. Process according to Claim 5, characterised in that the alkali or alkaline-earth metal fluoride is chosen from lithium, sodium, potassium and calcium fluorides.

7. Process according to any one of Claims 4 to 6, characterised in that the flux consists of $AlF_3$-$LiF$ in the $Li_3AlF_6$ (lithium cryolite) form, of $Li_3Na_3(AlF_6)_2$ (cryolithionite) or $3AlF_3 \cdot 5LiF$ (lithium chiolite).

8. Process according to any one of Claims 4 to 7, characterised in that the flux is employed in a proportion of at least 2 % and preferably from 4 to 20 % of flux relative to the weight of the transition or hydrated alumina subjected to calcination.

9. Process according to any one of Claims 4 to 8, characterised in that the transition or hydrated alumina consists of a powder in which at least 50 % (by weight) of the grains have a diameter smaller than 50 $\mu$m, the said alumina having a specific surface greater than 100 $m^2$/g.

10. Process according to Claim 8, characterised in that the alumina contains up to 15 % by weight of water.

11. Process according to any one of Claims 4 to 10 characterised in that the calcination temperature is between 900 and 1100°C.

12. Use of the $\alpha$ alumina macrocrystals according to either of Claims 1 and 2 for the manufacture of polishing products or as materials for reinforcing matrices, especially matrices made of ceramics or metallic or polymeric matrices.